(19) **Europäisches Patentamt / European Patent Office / Office européen des brevets**

(11) **EP 1 829 066 B1**

(12) **EUROPÄISCHE PATENTSCHRIFT**

(45) Veröffentlichungstag und Bekanntmachung des Hinweises auf die Patenterteilung:
**02.12.2009 Patentblatt 2009/49**

(51) Int Cl.:
*H01H 1/00* (2006.01)  *H01H 3/00* (2006.01)

(21) Anmeldenummer: **05825314.7**

(22) Anmeldetag: **22.12.2005**

(86) Internationale Anmeldenummer:
**PCT/EP2005/057074**

(87) Internationale Veröffentlichungsnummer:
**WO 2006/069957 (06.07.2006 Gazette 2006/27)**

(54) **VERFAHREN UND VORRICHTUNG ZUM SICHEREN BETRIEB EINES SCHALTGERÄTES**

METHOD AND DEVICE FOR THE SECURE OPERATION OF A SWITCHING DEVICE

PROCEDE ET DISPOSITIF POUR ASSURER LA SECURITE DE FONCTIONNEMENT D'UN APPAREIL DE DISTRIBUTION

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **23.12.2004 DE 102004062270**

(43) Veröffentlichungstag der Anmeldung:
**05.09.2007 Patentblatt 2007/36**

(73) Patentinhaber: **SIEMENS AKTIENGESELLSCHAFT**
**80333 München (DE)**

(72) Erfinder:
• **MITLMEIER, Norbert**
**92289 Ursensollen (DE)**

• **ZIMMERMANN, Norbert**
**92237 Sulzbach-Rosenberg (DE)**
• **ADUNKA, Robert**
**92237 Sulzbach-Rosenberg (DE)**
• **HARTINGER, Peter**
**92439 Bodenwöhr (DE)**
• **KOPPMANN, Bardo**
**92700 Kaltenbrunn (DE)**
• **NIEBLER, Ludwig**
**93164 Laaber (DE)**
• **POHL, Fritz**
**91334 Hemhofen (DE)**
• **WABNER, Alf**
**c/o Siemens Ltd. A. & D. D. WSGR-PD**
**Thane-400601 Maharashtra (IN)**

(56) Entgegenhaltungen:
**EP-A- 0 224 081    EP-A- 0 694 937**

EP 1 829 066 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

# EP 1 829 066 B1

## Beschreibung

Die vorliegende Erfindung betrifft ein Verfahren zum sicheren Betrieb eines Schaltgerätes gemäß dem Oberbegriff des Anspruchs 1 sowie eine entsprechende Vorrichtung gemäß dem Oberbegriff des Anspruchs 9, wie es z.B. in EP 0694 937 A2 offenbart sind.
Mit Schaltgeräten, insbesondere Niederspannungsschaltgeräten, lassen sich die Strombahnen zwischen einer elektrischen Versorgungseinrichtung und Verbrauchern und damit deren Betriebsströme schalten. Das heißt, indem vom Schaltgerät Strombahnen geöffnet und geschlossen werden, lassen sich die angeschlossenen Verbraucher sicher ein- und ausschalten.

Ein elektrisches Niederspannungsschaltgerät, wie beispielsweise ein Schütz, ein Leistungsschalter oder ein Kompaktstarter, weist zum Schalten der Strombahnen einen oder mehrere so genannte Hauptkontakte auf, die von einem oder auch mehreren Steuermagneten gesteuert werden können. Prinzipiell bestehen die Hauptkontakte dabei aus einer beweglichen Kontaktbrücke und festen Kontaktstücken, an die der Verbraucher und die Versorgungseinrichtung angeschlossen sind. Zum Schließen und Öffnen der Hauptkontakte wird ein entsprechendes Ein- oder Ausschaltsignal an die Steuermagnete gegeben, woraufhin diese mit ihrem Anker so auf die beweglichen Kontaktbrücken einwirken, dass die Kontaktbrücken eine Relativbewegung in Bezug auf die festen Kontaktstücke vollziehen und entweder die zu schaltende Strombahnen schließen oder öffnen.

Zur besseren Kontaktierung zwischen den Kontaktstücken und den Kontaktbrücken sind an Stellen, an denen beide aufeinander treffen, entsprechend ausgebildete Kontaktflächen vorgesehen. Diese Kontaktflächen bestehen aus Materialien, wie beispielsweise Silberlegierungen, die an diesen Stellen sowohl auf die Kontaktbrücke als auch die Kontaktstücke aufgebracht sind und eine bestimmte Dicke aufweisen.

Die Materialien der Kontaktflächen sind bei jedem der Schaltvorgänge einem Verschleiß unterworfen. Faktoren, die diesen Verschleiß beeinflussen können, sind:

■ zunehmender Kontaktabbrand oder Kontaktabrieb mit steigender Anzahl von Ein- und Ausschaltvorgängen,

■ zunehmende Verformungen,

■ zunehmende Kontaktkorrosion durch Lichtbogeneinwirkung oder

■ Umwelteinflüsse, wie beispielsweise Dämpfe oder Schwebstoffe usw.

Als Folge davon werden die Betriebsströme nicht mehr sicher geschaltet, was zu Stromunterbrechungen, Kontaktaufheizungen oder zu Kontaktverschweißungen führen kann.

So wird sich insbesondere mit zunehmendem Kontaktabbrand die Dicke der an den Kontaktflächen aufgebrachten Materialien verringern. Damit wird der Schaltweg zwischen den Kontaktflächen der Kontaktbrücke und der Kontaktstücke länger, was letztendlich die Kontaktkraft beim Schließen verringert. Als Folge davon werden mit zunehmender Anzahl von Schaltvorgängen die Kontakte nicht mehr richtig schließen. Durch die daraus resultierenden Stromunterbrechungen oder aber auch durch ein verstärktes Einschaltprellen kann es dann zu einer Kontaktaufheizung und damit zu einem zunehmenden Aufschmelzen des Kontaktmaterials kommen, was dann wiederum zu einem Verschweißen der Kontaktflächen der Hauptkontakte führen kann.

Ist ein Hauptkontakt des Schaltgerätes verschlissen oder sogar verschweißt, kann das Schaltgerät den Verbraucher nicht mehr sicher ausschalten. So wird gerade bei einem verschweißten Kontakt trotz des Ausschaltsignals zumindest die Strombahn mit dem verschweißten Hauptkontakt weiter strom- bzw. spannungsführend bleiben, und damit der Verbraucher nicht vollständig von der Versorgungseinrichtung getrennt. Da somit der Verbraucher in einem nicht sicheren Zustand verbleibt, stellt das Schaltgerät eine potentielle Fehlerquelle dar. So kann beispielsweise bei Kompaktstartern nach IEC 60 947-6-2, bei denen der Schutzmechanismus auf dieselbe Schaltstelle wirkt wie der elektromagnetische Antrieb beim betriebsmäßigen Schalten, dadurch die Schutzfunktion blockiert werden. Gerade solche Fehlerquellen sind aber zum sicheren Betrieb von Schaltgeräten und damit zum Schutz des Verbrauchers und der elektrischen Anlage zu vermeiden.

Aufgabe der vorliegenden Erfindung ist es, solche potentielle Fehlerquellen zu erkennen und entsprechend darauf zu reagieren.

Diese Aufgabe wird gelöst durch das Verfahren mit den Merkmalen des Anspruchs 1 sowie durch die Vorrichtung mit den Merkmalen des Anspruchs 9.

Die vorliegende Erfindung ermöglicht mit geringem Aufwand eine Kontaktverschweißung beim Ausschalten und damit einen nicht mehr sicheren Betrieb des Schaltgerätes zu erkennen, um entsprechend darauf reagieren zu können.

Erfindungsgemäß wird dazu eine Wegdifferenz, die der Anker nach dem Ein- oder Ausschalten zurücklegt, erkannt, und es werden Mittel zum Aufbrechen von verschweißten, dass heißt geschlossenen, Hauptkontakten durch eine Auslöseeinrichtung ausgelöst, wenn die erkannte Wegdifferenz einen vorgegebenen Wert unterschreitet und eine bestimmte Zeitdauer nach dem Ausschalten abgelaufen ist.

Der vorgegebene Wert wird dabei einer ermittelten Wegdifferenz entsprechen, bei der die Kontaktbrücke bei ausgeschaltetem Steuermagnet gerade noch mit den Kontaktstücken in Verbindung steht, so dass das Vorliegen einer Verschweißung angenommen werden kann. Die Wegdifferenz kann dabei direkt am Anker, aber auch an der mit dem Anker in Wirkverbindung stehenden Kontaktbrücke, oder an den Mitteln, die diese Wirkverbindung herstellen, ermittelt werden. Das Erkennen der Wegdifferenz kann z.B. auch durch eine Verbindung zwischen Anker und Auslösehebel, wie z.B. durch eine mechanische Koppeleinrichtung, erfolgen, die keine Kraft mehr auf den Auslösehebel ausübt, wenn die vom Anker zurückgelegte Wegdifferenz den vorgegebenen Wert nicht unterschreitet.

Ist nach Ablauf einer vorher bestimmten Zeitdauer die vom Anker zurückgelegte Wegdifferenz kleiner als dieser vorgegebene Wert, so kann davon ausgegangen werden, dass eine Verschweißung und damit ein nicht sicherer Betrieb des Schaltgerätes vorliegt. Durch das Auslösen entsprechender Mittel zum Aufbrechen der verschweißten Hauptkontakte können diese verschweißten Hauptkontakte wieder aufgebrochen und damit geöffnet werden. Durch weitere Maßnahmen, wie beispielsweise das Abschalten des Schaltgerätes, und/oder das Erzeugen entsprechender Warnsignale kann zusätzlich der nicht sichere Betrieb des Schaltgerätes angezeigt werden.

Weitere vorteilhafte Ausführungen und bevorzugte Weiterbildungen der Erfindung sind den Unteransprüchen zu entnehmen.

Die Erfindung sowie vorteilhafte Ausführungsbeispiele derselben werden im Weiteren anhand der nachfolgenden Figuren näher beschrieben. Es zeigen:

FIG 1     ein vereinfachtes Flussdiagramm des erfindungsgemäßen Verfahrens,
FIG 2     eine erste Ausführungsform der erfindungsgemäßen Vorrichtung,
FIG 3     eine zweite Ausführungsform der erfindungsgemäßen Vorrichtung,
FIG 4     eine dritte Ausführungsform der erfindungsgemäßen Vorrichtung,
FIG 5     eine vierte Ausführungsform der erfindungsgemäßen Vorrichtung,
FIG 6,7   schematische Darstellung der Zeitverläufe charakteristischer Größen zu FIG 2 und FIG 3,
FIG 8     eine fünfte Ausführungsform der erfindungsgemäßen Vorrichtung mit einem zeitverzögerten Abfrageelement in einer Ein-Position eines Schaltgerätes,
FIG 9     die fünfte Ausführungsform gemäß FIG 8 mit dem zeitverzögerten Abfrageelement in einer AUSPosition des Schaltgerätes und
FIG 10    die fünfte Ausführungsform gemäß FIG 8 mit dem zeitverzögerten Abfrageelement in einer "Verschweißt"-Position des Schaltgerätes.

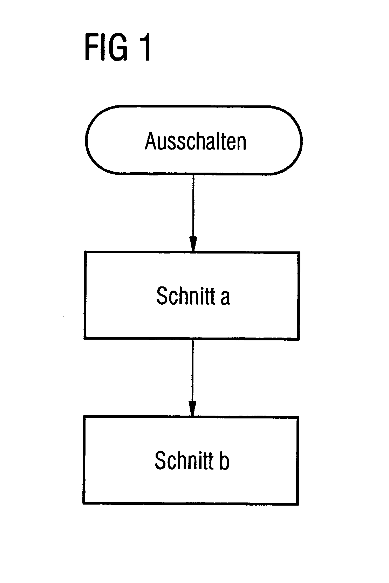

Wie in FIG 1 dargestellt werden bei dem erfindungsgemäßen Verfahren im Wesentlichen die beiden folgenden Schritte durchgeführt:

Schritt a)     Erkennen einer Wegdifferenz, die der Anker bzw. eine mit dem Anker (120) mechanisch verbundene Komponente nach dem Ein- oder Ausschalten zurücklegt und

Schritt b)     Auslösen von Mitteln zum Aufbrechen von verschweißten Hauptkontakten durch eine Auslöseeinrichtung, wenn die erkannte Wegdifferenz einen vorgegebenen Wert unterschreitet und eine bestimmte Zeitdauer nach dem Ausschalten abgelaufen ist.

Der Gedanke, der dem erfindungsgemäßen Verfahren zugrunde liegt, ist dabei, dass die Auslöseeinrichtung eine vorgegebene zeitliche Trägheit und damit eine Ansprechzeit, die im Folgenden auch als benötigte Auslösezeit bezeichnet wird, aufweist, die bei regulärem Schaltbetrieb größer ist als ein durch die vollständige Ankerbewegung festgelegtes Auslösezeitfenster. Das Auslösezeitfenster wird im Folgenden synonym für die Ausschaltzeit verwendet. Dadurch ist sichergestellt, dass nur im Fall der Kontaktverschweißung, nämlich dann, wenn der Anker aufgrund der Verschweißung der Kontakte nur eine geringe Wegdifferenz zurücklegt, nach einer durch die vorgegebene Trägheit festgelegten Zeitdauer die Auslösung erfolgt.

Durch diese Auslösung können entsprechende Mittel, das heißt Kraftspeicher, wie z.B. ein Schaltschloss, entriegelt werden, um den oder die verschweißten Hauptkontakte aufzubrechen. Zusätzlich kann ein weiteres Schaltelement vorgesehen sein, das im Falle der Auslösung den weiteren Betrieb des Schaltgerätes blockiert, und damit das Schaltgerät bis zu einem Rücksetzen gesperrt ist. Die Sperrung des betriebsmäßigen Schaltens kann zudem durch ein Display, durch ein mechanisches Anzeige- und Rücksetzglied, durch einen Meldekontakt oder über einen Datenbus angezeigt und/oder weiterverarbeitet werden.

Am Beispiel eines Schützes werden im Folgenden verschiedene Ausführungsformen der erfindungsgemäßen Vorrichtung näher beschrieben.

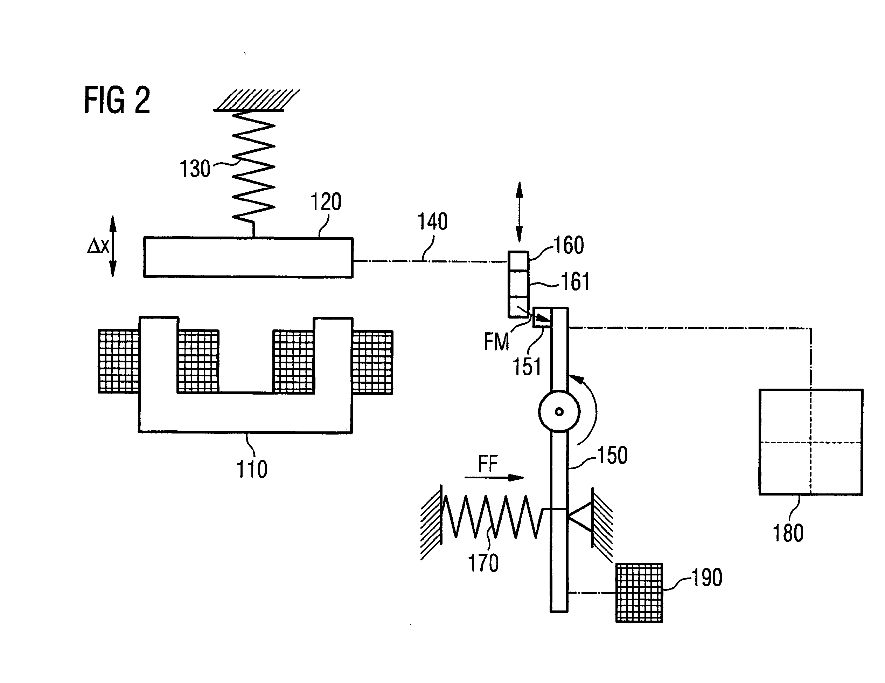

Im fehlerfreien und damit sicheren Betrieb des Schaltgerätes wird sich beim betriebsmäßigen Ausschalten des beispielsweise in FIG 2 dargestellten Steuermagneten 110, der Magnetanker 120 nach Absinken der Magnetkraft FM unter den Wert einer entgegengerichteten Federöffnungskraft einer Zugfeder 130 in Öffnungsrichtung bewegen. Nach wenigen Millimeter Öffnungsweg von beispielsweise 2 mm treffen die an den Anker 120 gekoppelten und hier nicht näher dargestellten mechanischen Betätigungsglieder gegen die Kontaktbrücke des oder der Hauptkontakte des Schaltgerätes. Mit der weiteren Öffnungsbewegung des Magnetankers 120 wird die Kontaktbrücke in ihre endgültige Öffnungsposition bewegt. Der gesamte Ankerweg $\Delta x$ von der Einschaltstellung bei geschlossenem Hauptkontakt bis zur Ausschaltstellung bei geöffnetem Hauptkontakt kann so ca. 6 mm betragen. Bei der beschleunigten Öffnungsbewegung des Magnetankers 120 aus der Einschaltstellung in die Ausschaltstellung wird bei Schalterschützen und Schützen eine typische Öffnungsgeschwindigkeit zwischen 0,5 m/s und 2 m/s erreicht. Im Fall einer Kontaktverschweißung wird die Öffnungsbewegung des Ankers im vorliegenden Beispiel nach 2 mm Öffnungsweg abrupt gebremst. Nach vielleicht einem Millimeter weiterem Öffnungsweg wird die Ankerbewegung dann vollständig gestoppt, nachdem das mechanisches Spiel überwunden und die Verformung ausgebildet sind.

Zwischen dem nichtverschweißten Fall und dem verschweißten Zustand der Kontakte beträgt die Differenz $\Delta x$ des Ankerweges somit ca. 3 mm. Dieser Differenzweg $\Delta x$ wird im nichtverschweißten Fall dann z.B. in 1,5 ms, was einer Geschwindigkeit von v = 2 m/s entspricht, oder in 6 ms, was einer Geschwindigkeit von v = 0,5 m/s entspricht, zurückgelegt. Wird dieser Differenzweg $\Delta x$ als mechanisches Auslösefenster betrachtet, so entspricht diesem ein Auslösezeitfenster mit der Zeitdauer 1,5 ms oder 6 ms. Der zeitlich träge Auslösemechanismus muss also die Bedingung erfüllen, im sicheren Betrieb während dieses kurzen Zeitfensters nicht anzusprechen.

Anhand der FIG 2 soll nun eine erste Ausführungsform der erfindungsgemäßen Vorrichtung erläutert werden.

Die Vorrichtung umfasst hier einen drehbar gelagerten Auslösehebel 150 als Auslöseeinrichtung. Dieser Auslösehebel 150 wird durch die Magnetkraft FM eines Permanentmagneten 151, der mit dem Auslösehebel 150 fest verbunden ist, gegen eine entgegenwirkende Kraft FF einer Auslösefeder 170 an einer verschiebbaren ferromagnetischen Kulisse 160 berührungsfrei gefesselt. Die ferromagnetische Kulisse 160 besteht aus einem Blech mit einer Ausnehmung 161 und wird bei der Schließ- und Öffnungsbewegung durch Ankopplung 140 an den Magnetanker 120 mit diesem mitbewegt. Permanentmagnet 151 und Kulisse 160 sind nun derart zueinander positioniert, dass im Fall einer Kontaktverschweißung, das heißt einer Bewegung des Ankers von wenigen Millimetern, die Kulissenausnehmung 161 dem Permanentmagneten 151 gegenübersteht, und damit dessen magnetische Fesselungskraft FM unter den Wert der entgegengerichteten Auslösefederkraft der Feder 170 sinkt. Das bedeutet, dass die Fesselungskraft FM nur dann abnimmt, wenn die Kulissenausnehmung 161 dem Permanentmagneten 151 gegenübersteht, weil der Anker nur eine Wegdifferenz $\Delta x$ zurückgelegt hat, die einen bestimmten Wert, im vorliegenden Beispiel 3 mm, unterschreitet. Da sich die Kulisse 160 aufgrund der Verschweißung nicht weiterbewegt, wirkt ein ständiger Kraftüberschuss der Auslösefeder 170, so dass nach Ablauf der durch die zeitliche Trägheit vorgegebenen Zeitdauer der Auslösehebel 150 in die Auslösestellung bewegt wird und damit beispielsweise ein Schaltschloss 180 entklinkt wird.

Durch eine entsprechend hohe Federkraft des Schaltschlosses 180, das auf den Hauptkontakt einwirkt, kann dann die Kontaktverschweißung aufgebrochen werden, wodurch sich der Anker 120 mit den Kontaktbrücken in die Ausschaltstellung bewegt. In diesem Fall, bei dem das Schaltschloss 180 in eine Ausschalt- bzw. Auslösestellung geht, kann es zweckmäßig sein, diese Schaltschlossstellung mit einer Trennung des Steuerstromkreises des Magnetantriebes 110 zu verknüpfen, um zur Fehlererkennung das Schaltgerät gegen den weiteren Betrieb zu schützen. Erst durch eine aktive Quittierung oder Rücksetzung, beispielsweise im Rahmen einer Wartungsmaßnahme am Schaltgerät, wird dann der Auslösehebel 150 wieder in den Zustand zurückgesetzt, in der er durch die Magnetkraft FM des Permanentmagneten 151 an die ferromagnetische Kulisse 160 gefesselt ist, und damit die Auslösevorrichtung für den weiteren sicheren Betrieb verriegelt ist.

Ergänzend kann, wie in FIG 2 dargestellt, vorgesehen sein, die Auslösefunktion zur Behebung von Kontaktverschweißungen beim Einschalten des Magnetantriebes 110 zu sperren. Damit kann zum Beispiel das Problem umgangen werden, dass das Auslösezeitfenster aufgrund einer geringen Ankerschließgeschwindigkeit größer ist als die Ansprechzeit des Auslösemechanismus. So kann eine fehlerhafte Auslösung vermieden werden. Dazu wird der Auslösehebel 150 durch eine zusätzliche, gleichzeitig mit dem Magnetantrieb 110 eingeschaltete, Magnetspule 190 in der "Nichtausgelöststellung" gefesselt.

Zusätzlich kann vorgesehen sein, die zeitliche Trägheit des Auslösemechanismus beim Ausschaltvorgang dadurch zu vergrößern, dass diese Magnetspule 190 nach Unterbrechung der Versorgungs- und damit der Steuerspannung durch einen geladenen Kondensator für eine begrenzte Zeit, in der das Kulissenfenster am Permanentmagneten vorbeigeführt wird, stromerregt bleibt.

Als weitere Ausführungsvariante kann eine zusätzliche Fesselung des Auslösehebels 150 beim Einschalten des Magnetantriebes 110 dadurch erreicht werden, indem das nicht näher dargestellte magnetische Streufeld des Ankerluftspaltes eine Fesselungskraft FM auf eine Komponente ausübt, die mit dem Auslösehebel 150 verbunden ist. Im Fall einer magnetischen Gleichfelderregung kann dies der Permanentmagnet 151 des Auslösehebels 150 sein, und im Fall einer magnetischen Wechselfelderregung eine zusätzliche, auf den Auslösehebel 150 aufgebrachte, ferromagnetische Komponente.

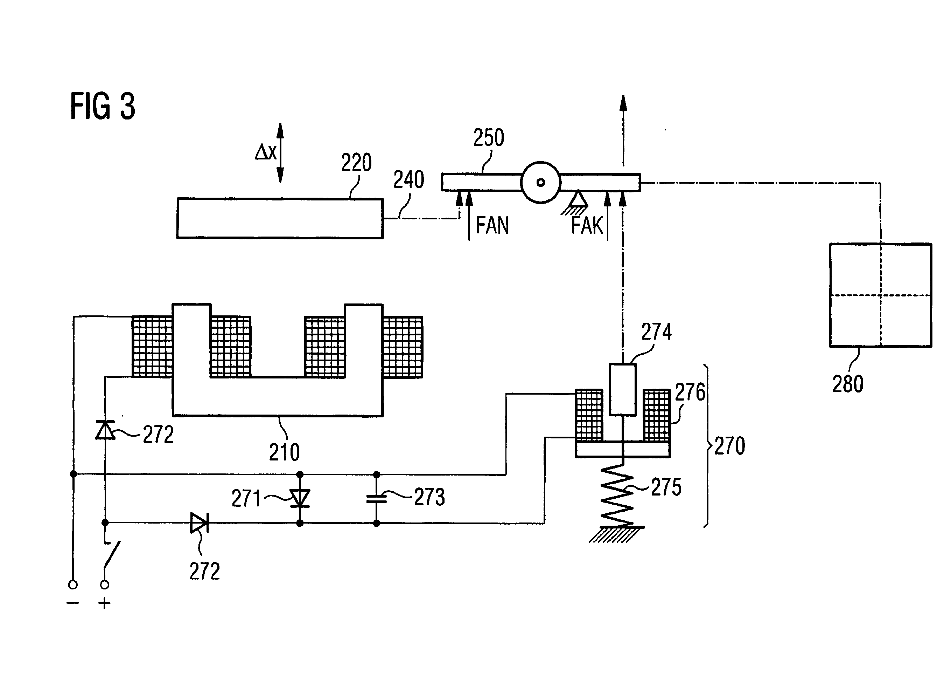

FIG 3 zeigt eine zweite Ausführungsform der erfindungsgemäßen Vorrichtung. Als mechanisches Auslösefenster wird hier der gesamte Ankerweg von der Einschaltstellung bis zur Ausschaltstellung betrachtet. Hierzu korrespondiert ein Auslösezeitfenster von z.B. 10 - 20 Millisekunden Breite, wenn im Beispiel des Schalterschützes die mittlere Öffnungsgeschwindigkeit des Ankers zwischen 0,3 m/s und 0,6 m/s liegt. Das Auslösezeitfenster kann noch durch die Abklingzeit des Magnetfeldes nach dem Ausschaltkommando des Steuerstromkreises vergrößert sein. Wie bei FIG 2 muss der zeitlich träge Auslösemechanismus von FIG 3 also die Bedingung erfüllen, während dieses Auslösezeitfensters nicht anzusprechen.

Der Auslösemechanismus enthält dazu eine Sperreinrichtung, wie z.B. einen Sperrhebel 240, die vom Magnetanker 220 des betriebsmäßigen Magnetantriebes 210 betätigt sein kann und eine Auslöseeinrichtung, wie z.B. einen Auslösehebel 250, die von einem zusätzlichen Aktor 270 betätigt wird. Die Sperreinrichtung 240 und die Auslöseeinrichtung 250 sind in der Weise miteinander verknüpft, dass nur im nichtgesperrten Zustand das Auslösen möglich ist. Eine Realisierungsmöglichkeit hierzu ist, dass der Sperrhebel 240 und der Auslösehebel 250 eine mechanische Einheit bilden, und die Sperrkraft FAN des Magnetankers 220 die Auslösekraft FAK des Aktors 270 erheblich überwiegt. Es können alternativ auch der Sperrhebel 240, der Auslösehebel 250 und die als punktstrichlierter Pfeil in der FIG 3 eingezeichnete mechanische Wirkverbindung zum Tauchanker 274 des zusätzlichen Ankers 270 als mechanische Einheit ausgebildet sein. Damit im nichtverschweißten Fall keine Auslösung erfolgt, muss die Sperrung der Auslöseeinrichtung 250 durch den Magnetanker 220 vor der versuchten Auslösung durch den Aktor 270 erfolgen. Das Auslösezeitfenster ist in diesem Fall für eine Auslösung durch den Aktor 270 zu kurz. Dem Aktor 270 wird hierzu für den Ausschaltvorgang ein zeitlich träges Verhalten gegeben. Als Aktor 270 kann dabei ein Magnetauslöser bekannter Bauweise verwendet werden.

Bei einem Schalterschütz mit DC-Magnetantrieb kann das zeitlich träge Verhalten dieses Magnetauslösers 270 durch eine Freilaufschaltung, das heißt durch eine zum Magnetauslöser 270 parallel geschalteten Freilaufdiode 271 hergestellt werden. Die Steuerstromkreise des DC-Magnetantriebes 210 und des Magnetauslösers 270 sind dabei beispielsweise über eine Diodenschaltung gegenseitig elektrisch entkoppelt. Beim Einschalten des Magnetantriebes 210 wird gleichzeitig der Magnetauslöser 270 eingeschaltet, und es wird der Magnetauslöseranker 274 dabei in die Nichtauslöseposition bewegt und dort gegen die Auslöserfeder 275 magnetisch gefesselt, solange auch der Anker 220 im Einschaltzustand verbleibt. Beim Ausschalten des DC-Magnetantriebs 210 wird gleichzeitig der Magnetauslöser 270 ausgeschaltet. Durch den Freilaufkreis 271, 276 wird das Abklingen des Magnetfeldes des Magnetauslösers 270 zeitlich verzögert und der Magnetauslöseranker 274 fällt erst nach einer Verzögerungszeit ab. Eine zusätzliche Verzögerung wird erreicht, indem ein geladener Kondensator 273, der parallel zum Freilaufkreis 271, 276 geschaltet ist, den Magnetauslöser 270 noch eine vorgegebene Zeitspanne über das Ausschaltsignal des Magnetantriebes 210 hinaus mit Spannung versorgt.

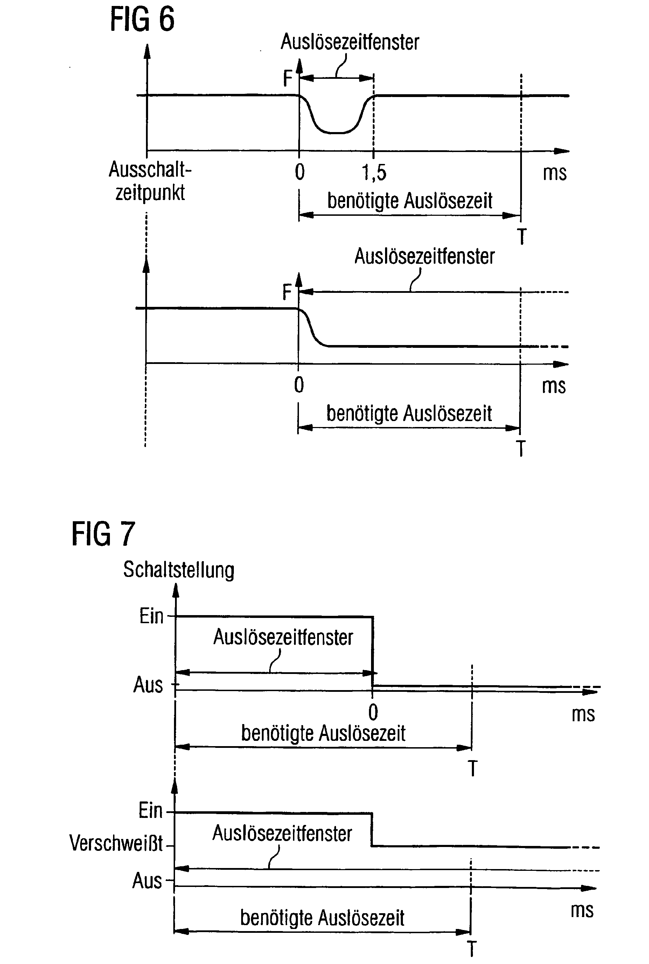

FIG 6 und 7 zeigen die entsprechenden Diagramme der nach dem Ausschalten wirkenden Kräfte bzw. der nach dem Ausschalten vorliegender Schaltstellung für die beiden in FIG 2 und FIG 3 dargestellten Ausführungsformen. Dabei zeigt insbesondere das obere Diagramm von FIG 6 das Kraft-/Zeitdiagramm für die erste, in FIG 2 dargestellte Ausführungsform im normalen, das heißt nichtverschweißten Betrieb, und das untere Diagramm von FIG 6 das Kraft-/Zeitdiagramm im gestörten, das heißt verschweißten Betrieb. Entsprechend zeigt das obere Diagramm der FIG 7 die Schaltstellung der in FIG 3 dargestellten Ausführungsform im normalen Betrieb, und das untere Diagramm der FIG 7 dieselbe Ausführung im gestörten Betrieb. Die Zeitdauer, die bei den erfindungsgemäßen Verfahren und der erfindungsgemäßen Vorrichtung dabei abgelaufen sein muss, ist hier mit τ dargestellt.

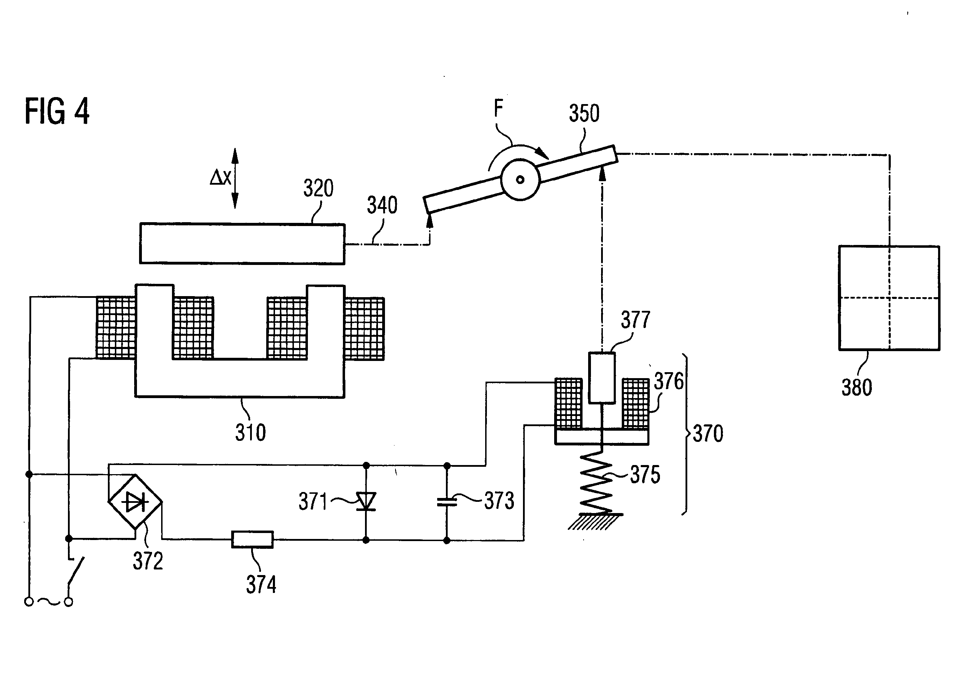

FIG 4 zeigt eine dritte Ausführungsform als Alternative zu der in FIG 3 dargestellten Ausführungsform, wenn das Schalterschütz mit einem AC-Magnetantrieb 310 ausgerüstet ist.

Der Steuerstromkreis des Magnetauslösers 370 ist hier über einen Brückengleichrichter 372 an den Steuerstromkreis des AC-Magnetantriebes 310 angeschlossen, und das zeitlich träge Verhalten des Magnetauslösers 370 kann wiederum durch eine Freilaufdiode 371 hergestellt werden. Um eine zusätzliche Verzögerung des Magnetauslösers 370 zu erreichen, kann auch hier ein geladener Kondensator 373 zu dem Freilaufkreis 371, 376 parallel geschaltet sein. Bei der Schaltung in FIG 4 nutzt der AC-Magnetantrieb 310 bei der Ausschaltung des Steuerstromkreises den Stromkreis des Magnetauslösers 370 als eine Art Freilaufkreis 371, 376, was zu einem verzögerten Abfall des Magnetankers 374 des Magnetantriebes 310 führt. Um diese Verzögerung zu beschränken, ist im Auslöserstromkreis ein Begrenzungswiderstand 374 vorgesehen. Die Zeitkonstante T des Magnetfeldabklingens beim Ausschalten des AC-Magnetantriebes 310 ist dann durch eine Zeitdauer gegeben, die durch die Beziehung

$$T = (L_{Magnetantrieb} + L_{Auslöser}) / (R_{Magnetantrieb} + R_{Auslöser} + R)$$

bestimmt ist.

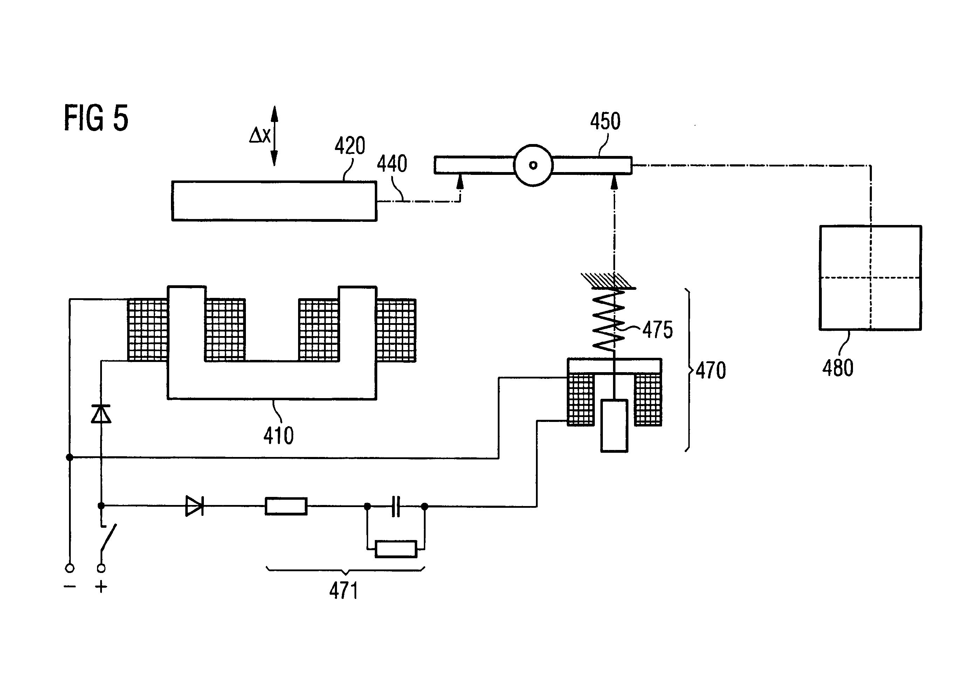

FIG 5 zeigt eine vierte Ausführungsform einer Vorrichtung zum sicheren Betrieb eines Schaltgerätes. Hier wirkt die Auslöseeinrichtung 450 allerdings beim Einschalten des betriebsmäßigen Schaltgeräteantriebes 410.

Hierzu ist ein Aktor 470 vorgesehen, welcher nahezu zeitgleich mit dem Einschaltsignal angesteuert wird und dessen Pulsdauer durch eine Zeitsteuerung auf eine vorgegebene Zeitdauer, z.B. 1 ms bis 10 ms, begrenzt ist. Derartige Zeitsteuerung, sowohl in analoger als auch digitaler Elektronik, sind dem Fachmann bekannt. So kann aus oder zu dem Einschaltsignal des Steuermagneten 410 ein Rechtecksignal generiert werden, zu dessen steigender Signalflanke ein einzelner Spannungspuls vorgegebener Zeitdauer erzeugt wird. Die von der Zeitsteuerung vorgegebene Zeitdauer, zumindest ein wesentlicher Teil davon, wird als Ansprechzeit des Aktors 470 bezeichnet. Während der Ansprechzeit kann der Aktor 470 genügend Energie zur Auslösung gegen die Aktor-Fesselungsfeder 475 und die Schaltschlossverklinkung aufnehmen, wenn er sich ungehindert in Auslöserichtung bewegen kann.

Im Fall einer Kontaktverschweißung, d.h. bei nicht gesperrtem Aktor 470, löst dieser das Schaltschloss 480 beim Einschalten des betriebsmäßigen Schaltgeräteantriebes 410 unverzögert aus. Das mechanische Auslösefenster ist hier durch die Wegdifferenz $\Delta x$ zwischen Ausschaltstellung und Verschweißstellung der beweglichen Antriebskomponente gegeben, und das Auslösezeitfenster ist größer als die vorgegebene Ansprechzeit des Aktors 470.

Bei nichtverschweißten Kontakten ist die Länge des mechanischen Auslösefensters durch die Wegdifferenz $\Delta x$ zwischen der Ausschaltstellung und der momentanen Position der beweglichen Antriebskomponente während des Ansteuerpulses gegeben. Dieses mechanische Auslösezeitfenster wird vom Aktor 470 in einer Zeit, die kürzer als die Ansprechzeit des Aktors 470 ist, durchlaufen, so dass nicht genügend Energie für eine Auslösung des Schaltschlosses 480 aufgenommen wird.

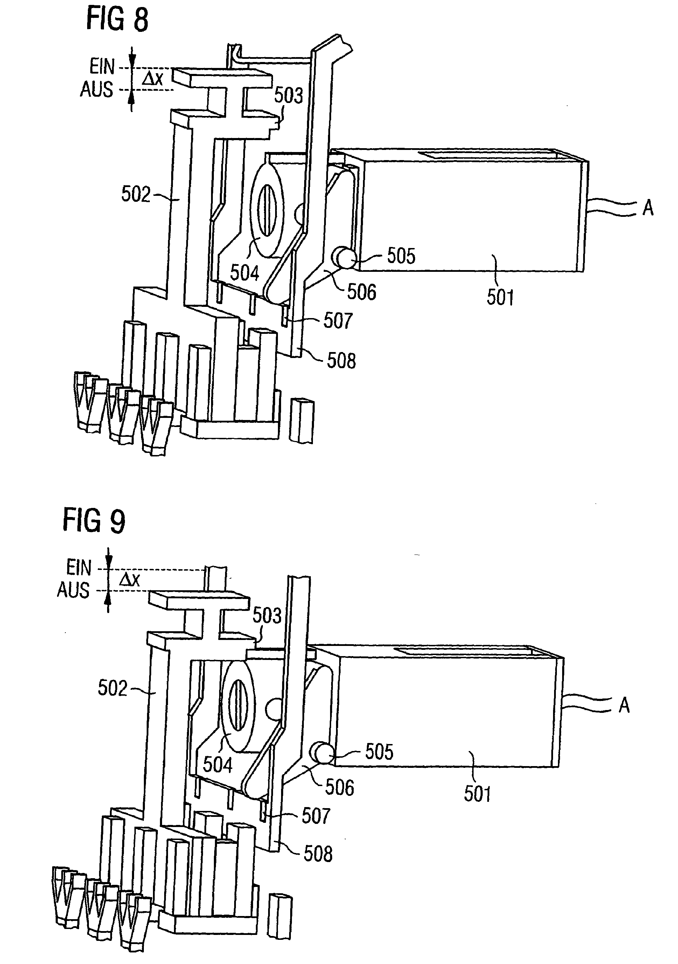

FIG 8 zeigt eine fünfte Ausführungsform der erfindungsgemäßen Vorrichtung mit einem zeitverzögerten Abfrageelement 501 in einer Ein-Position eines Schaltgerätes. Die erfindungsgemäße Vorrichtung weist ein Abfrageelement 501 als Auslöseeinrichtung auf, welches nach dem Ausschalten des Schaltgerätes und nach Ablauf einer bestimmten Zeitdauer die von einem Hilfskontaktschieber 502 zurückgelegte Wegdifferenz $\Delta x$ ermittelt. Der Hilfskontaktschieber 502 steht dabei mit einem nicht weiter eingezeichneten Anker eines Steuermagneten oder elektromagnetischen Antriebs in einer mechanischen Wirkverbindung. Beim Einschalten des Schaltgerätes bewegt sich mit dem Anker der Hilfskontaktschieber 502 zum Öffnen der Hauptkontakte in der gezeigten Figur 8 nach unten. Zur Verdeutlichung sind die beiden Schaltpositionen des Schaltgerätes mit den Worten "EIN" und "AUS" gekennzeichnet. Der Abstand zwischen diesen beiden Schaltpositionen entspricht der zurückgelegte Wegdifferenz $\Delta x$. Das Abfrageelement 501 ist weiterhin gemäß der Erfindung dazu ausgebildet, Mittel 505-508 zum Aufbrechen von verschweißten Hauptkontakten auszulösen, wenn die zurückgelegte Wegdifferenz $\Delta x$ einen vorgegebenen Wert unterschreitet.

Im Beispiel der Figur 8 ist das Abfrageelement 501 als Aktor, insbesondere als Hubmagnet, ausgebildet, der bei Stromerregung über die gezeigten elektrischen Anschlüsse A einen zylindrischen Bolzen 504 zur mechanischen Abtastung einer Position auf dem Hilfskontaktschieber 502 ausfährt. Dabei wird nach dem Ausschalten des Schaltgerätes eine vorbestimmte Zeit zum Ausfahren des Bolzens 504 abgewartet, die z.B. in einem Bereich von 200 ms bis 500 ms liegt.

FIG 9 zeigt die fünfte Ausführungsform gemäß FIG 8 mit dem zeitverzögerten Abfrageelement 501 in einer AUS-Position des Schaltgerätes. FIG 9 zeigt den Hilfskontaktschieber 502 in der "unteren" Schaltposition, wobei nun eine Position 503 an dem Hilfskontaktschieber 502 abgetastet wird. Im vorliegenden Fall erfolgt die Abtastung dadurch, dass die Betätigung des Bolzens 504 des Abfrageelements 501 durch einen Vorsprung 503 am Hilfskontaktschieber 502, der die abzutastende Position ausbildet, blockiert bzw. 504 eingeschränkt wird, falls die zurückgelegte Wegdifferenz $\Delta x$ den vorgegebenen Wert nicht unterschreitet. In diesem Falle erfolgt keine Auslösung der Mittel 505-508 zum Aufbrechen der Hauptkontakte.

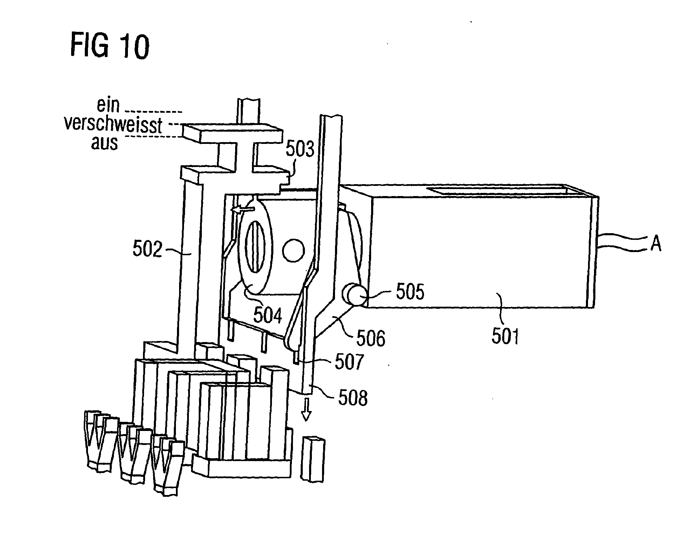

FIG 10 zeigt die fünfte Ausführungsform gemäß FIG 8 mit dem zeitverzögerten Abfrageelement 501 in einer "Verschweißt"-Position des Schaltgerätes. Wie die Figur 10 zeigt, wird nun der Bolzen 503 des Abfrageelements 501 beim Ausfahren nicht mehr blockiert, sondern ungehindert aus dem Gehäuse des Abfragelements 501 bewegt. In dieser Stellung des Hilfskontaktschiebers 502 hat die Wegdifferenz $\Delta x$ den vorgegebenen Wert bereits unterschritten, da der mit dem nicht weiter gezeigten Hauptkontaktschieber verbundene Hilfskontaktschieber 502 nicht vollends in die AUS-Position zurückgekehrt ist. Durch das ungehinderte Ausfahren des Aktors bzw. des Bolzens 504 des Hubmagneten 501 wird die dabei erzeugte Kraft über einen Schwenkhebel 506, der im Gehäuse des Hubmagneten 501 drehbar gelagert ist, auf einen Aufbrechschieber 508 übertragen, der dann den verschweißten Hauptkontakt aufbrechen kann. Zur Verdeutlichung sind Pfeile zu den Bewegungen des Bolzens 503 des Aktors 501 sowie des Aufbrechschiebers 508 eingezeichnet.

In den Figuren 8 bis 10 der vorliegenden Erfindung bewegt sich der Hilfskontaktschieber 502 senkrecht zu der Bewegungsrichtung des Aktors 501 bzw. des Abfrageelements. Dies muss aber nicht zwangsläufig so sein. Genau so gut könnte das Abfrageelement die gleiche Bewegungsrichtung wie der Hilfskontaktschieber 502 aufweisen. So könnte sich z.B. der Hilfskontaktschieber 502 nach "unten" bewegen, wenn er die Hauptkontakte öffnet, und das "zeitverzögerte" Abfrage- und Auslöseelement 501 könnte sich bei einer Auslösung nach oben bewegen. Ist dann der Hilfskontaktschieber 502 ganz in seiner AUS-Stellung angelangt und kräftemäßig stärker als das Abfrage- und Auslöseelement 501, so wird das Abfrage- und Auslöseelement 501 vom Hilfskontaktschieber 502 gehalten. Dieses kann folglich nicht mehr auslösen.

Die Abfrage der Schaltposition des Hilfskontaktschiebers 502 gemäß FIG 8 bis FIG 10 kann alternativ auf induktivem, kapazitivem, optischem oder auf messtechnisch anderweitig bekanntem Wege erfolgen. Die zuvor gezeigten Komponenten des Abfrage- und Auslöseelements sowie des Aufbrechmittels können vorteilhaft auch in einer Funktionseinheit 501, 504-505 zusammengefasst und modulartig in ein Schaltgerät integriert werden kann.

**Patentansprüche**

1. Verfahren zum sicheren Betrieb eines Schaltgerätes mit zumindest einem ein- und ausschaltbaren Hauptkontakt, der Kontaktstücke und eine bewegliche Kontaktbrücke aufweist, und mit zumindest einem Steuermagneten (110), der einen beweglichen Anker (120) aufweist, wobei der Anker (120) und die Kontaktbrücke in einer derartigen Wirkverbindung stehen, dass beim Ein- oder Ausschalten der entsprechende Hauptkontakt (1) geschlossen oder geöffnet werden kann, mit den Schritten:

   a) Erkennen einer Wegdifferenz ($\Delta x$), die der Anker (120) bzw. eine mit dem Anker (120) mechanisch verbundene Komponente (502) nach dem Ein- oder Ausschalten zurücklegt, und **gekennzeichnet durch**
   b) Auslösen von Mitteln (180) zum Aufbrechen von verschweißten Hauptkontakten **durch** eine Auslöseeinrichtung (150), wenn die erkannte Wegdifferenz ($\Delta x$) einen vorgegebenen Wert unterschreitet und eine bestimmte Zeitdauer nach dem Ausschalten abgelaufen ist.

2. Verfahren nach Anspruch 1, **dadurch gekennz eichnet, dass** das Mittel (180) zum Aufbrechen einen Kraftspeicher umfasst, der entklinkt wird.

3. Verfahren nach Anspruch 1 oder 2, **dadurch gekennzeichnet, dass** die Auslösung durch einen Auslösehebel (150) als Auslöseeinrichtung erfolgt, der drehbar gelagert ist, und der an einem Ende mit dem Anker (120) und an dem anderen Ende mit Mitteln (170) zum Erzeugen einer Gegenkraft (FF) in Wirkverbindung steht.

4. Verfahren nach Anspruch 3, **dadurch gekennzeichnet, dass** das Erkennen der Wegdifferenz ($\Delta x$) durch eine ferromagnetische Kulisse (160) erfolgt, die zusammen mit dem Anker (120) bewegt wird, die in Wirkverbindung mit einem Magneten (151) auf dem Auslösehebel (150) steht und die eine Kraftbindung (FM) zwischen Kulisse (160) und Magnet (151) aufhebt, wenn die vom Anker (120) zurückgelegte Wegdifferenz ($\Delta x$) den vorgegebenen Wert unterschritten hat.

5. Verfahren nach einem der Ansprüche 1 bis 3, **dadurch gekennzeichnet, dass** das Erkennen der Wegdifferenz ($\Delta x$) durch eine Verbindung (140) zwischen Anker (120) und Auslösehebel (150) erfolgt, die keine Kraft mehr auf den Auslösehebel (150) ausübt, wenn die vom Anker (120) zurückgelegte Wegdifferenz ($\Delta x$) den vorgegebenen Wert nicht unterschreitet.

6. Verfahren nach Anspruch 1, **dadurch gekennzeichnet, dass** nach dem Ausschalten und nach Ablauf der bestimmten Zeitdauer die vom Anker bzw. von der Komponente (502) zurückgelegte Wegdifferenz ($\Delta x$) mittels eines Abfrageelements (501) als Auslöseeinrichtung ermittelt wird, wobei das Abfrageelement (501) die Mittel zum Aufbrechen von verschweißten Hauptkontakten auslöst, wenn die zurückgelegte Wegdifferenz ($\Delta x$) den vorgegebenen Wert unterschreitet.

7. Verfahren nach Anspruch 6, **dadurch gekennzeichnet, dass** das Abfrageelement (501) ein Aktor ist, welcher nach dem Ausschalten und nach Ablauf der bestimmten Zeitdauer betätigt wird, um eine Position (503) des Ankers bzw. der damit verbundenen Komponente (502) abzutasten, wobei die Betätigung des Aktors (501) durch den Anker bzw. durch die damit verbundene Komponente blockiert oder zumindest eingeschränkt wird, wenn die zurückgelegte Wegdifferenz ($\Delta x$) den vorgegebenen Wert nicht unterschreitet.

8. Verfahren nach Anspruch 7, **dadurch gekennzeichnet, dass** der Aktor (501) im Falle der ungehinderten Betätigung die mit dem Aktor (501) in einer mechanischen Wirkverbindung stehenden Mittel (505-508) zum Aufbrechen von verschweißten Hauptkontakten betätigt.

9. Vorrichtung zum sicheren Betrieb eines Schaltgerätes, wobei das Schaltgerät zumindest einen ein- und ausschaltbaren Hauptkontakt, der Kontaktstücke und eine bewegliche Kontaktbrücke aufweist, und zumindest einen Steuermagneten (110), der einen beweglichen Anker (120) aufweist, umfasst, wobei der Anker (120) und die Kontaktbrücke so in Wirkverbindung stehen, dass beim Ein- oder Ausschalten der entsprechende Hauptkontakt geschlossen oder geöffnet werden kann,
**dadurch gekennzeichnet, dass**

- eine Auslöseeinrichtung (150) vorgesehen ist, die Mittel (180) zum Aufbrechen von verschweißten Hauptkontakten auslöst, und
- dass die Auslösung dann erfolgt, wenn beim Ausschalten die vom Anker (120) bzw. von einer mit dem Anker (120) mechanisch verbundenen Komponente (502) zurückgelegte Wegdifferenz ($\Delta x$) einen vorgegebenen Wert unterschreitet, und eine bestimmte Zeitdauer nach dem Abschalten abgelaufen ist.

10. Vorrichtung nach Anspruch 9, **dadurch gekennzeichnet, dass** die Mittel (180) zum Aufbrechen einen Kraftspeicher umfassen, der von dem Auslösehebel (150) entklinkbar ist.

11. Vorrichtung nach Anspruch 9 oder 10, **dadurch gekennzeichnet, dass** die Auslöseinrichtung (150) ein Auslösehebel ist, der drehbar gelagert ist, und der an einem Ende mit dem Anker (120) und an dem anderen Ende mit Mitteln (170) zum Erzeugen einer Gegenkraft (FF) in Wirkverbindung steht.

12. Vorrichtung nach Anspruch 11, **dadurch gekennzeichnet, dass** eine ferromagnetische Kulisse (160) vorgesehen ist, die zusammen mit dem Anker (120) bewegt wird, und in Wirkverbindung mit einem Magneten (151) auf dem Auslösehebel (150) steht, und die eine Kraftbindung (FM) zwischen Kulisse (160) und Magnet (151) aufhebt, wenn die vom Anker (120) zurückgelegte Wegdifferenz ($\Delta x$) den vorgegebenen Wert unterschritten hat.

13. Vorrichtung nach einem der Ansprüche 9 bis 11, **dadurch gekennzeichnet, dass** eine mechanische Koppeleinrichtung (140) zwischen Anker (120) und Auslösehebel (150) vorgesehen ist, die so ausgebildet ist, dass von der Koppeleinrichtung (140) keine Kraft mehr auf den Auslösehebel (150) ausgeübt wird, wenn die vom Anker (120) zurückgelegte Wegdifferenz ($\Delta x$) den vorgegebenen Wert nicht unterschreitet.

14. Vorrichtung nach Anspruch 9, **dadurch gekennzeichnet, dass** ein Abfrageelement (501) als Auslöseeinrichtung vorgesehen ist, welches nach dem Ausschalten und nach Ablauf der bestimmten Zeitdauer die vom Anker bzw. von der Komponente (502) zurückgelegte Wegdifferenz ($\Delta x$) ermittelt und welches die Mittel zum Aufbrechen von verschweißten Hauptkontakten auslöst, wenn die zurückgelegte Wegdifferenz ($\Delta x$) den vorgegebenen Wert unterschreitet.

15. Vorrichtung nach einem der Ansprüche 9 bis 11, **dadurch gekennzeichnet, dass** das Abfrageelement (501) ein Aktor ist, welcher nach dem Ausschalten und nach Ablauf der bestimmten Zeitdauer betätigbar ist, um eine Position (503) des Ankers bzw. der damit verbundenen Komponente (502) abzutasten, wobei durch diese die Betätigung des Aktors (501) blockiert oder zumindest eingeschränkt wird, falls die zurückgelegte Wegdifferenz ($\Delta x$) den vorgegebenen Wert nicht unterschreitet.

16. Vorrichtung nach einem der Ansprüche 9 bis 11, **dadurch gekennzeichnet, dass** im Falle der ungehinderten Betätigung die mit dem Aktor (501) in einer mechanischen Wirkverbindung stehenden Mittel (505-508) zum Aufbrechen von verschweißten Hauptkontakten mittels des Aktors (501) betätigbar sind.

17. Schaltgerät, das zum sicheren Schalten von Verbrauchern das Verfahren nach einem der Ansprüche 1 bis 8 durchführt, wobei das Schaltgerät ein Schütz oder ein Leistungsschalter oder ein Kompaktabzweig ist.

18. Schaltgerät zum sicheren Schalten von Verbrauchern mit einer Vorrichtung nach einem der Ansprüche 9 bis 16, wobei das Schaltgerät ein Schütz oder ein Leistungsschalter oder ein Kompaktabzweig ist.

19. Schaltgerät nach Anspruch 17 oder 18, **dadurch gekennzeichnet, dass** das Schaltgerät ein dreipoliges Schaltgerät mit drei Hauptkontakten zum Ein- und Ausschalten von drei Strombahnen mit einem Steuermagneten (120) ist.

**Claims**

1. Method for safe operation of a switching device having at least one main contact which can be connected and disconnected and has contact pieces and a moving contact link, and having at least one control magnet (110) which has a moving armature (120), with the armature (120) and the contact link being operatively connected such that

the appropriate main contact (1) can be closed or opened during connection or disconnection, having the following steps:

a) identification of a movement distance difference ($\Delta x$) which the armature (120) or a component (502) which is mechanically connected to the armature (120) travels through after connection or disconnection, and **characterized by**
b) initiation of means (180) for breaking open welded main contacts by means of an initiation device (150) when the identified movement distance difference ($\Delta x$) is less than a predetermined value and a specific time period has elapsed after disconnection.

2. Method according to Claim 1, **characterized in that** the means (180) for breaking open comprises a force energy store which is unlatched.

3. Method according to Claim 1 or 2, **characterized in that** the initiation is carried out by means of an initiation lever (150) as an initiation device, which is mounted such that it can rotate and is operatively connected at one end to the armature (120) and at the other end to means (170) for production of an opposing force (FF).

4. Method according to Claim 3, **characterized in that** the movement distance difference ($\Delta x$) is identified by means of a ferromagnetic slotted link (160) which is moved together with the armature (120), is operatively connected to a magnet (151) on the initiation lever (150) and cancels a force link (FM) between the slotted link (160) and the magnet (151) when the movement distance difference ($\Delta x$) traveled by the armature (120) is less than the predetermined value.

5. Method according to one of Claims 1 to 3, **characterized in that** the movement distance difference ($\Delta x$) is identified by a connection point (140) between the armature (120) and the initiation lever (150) which no longer exerts any force on the initiation lever (150) when the movement distance difference ($\Delta x$) traveled by the armature (120) is not less than the predetermined value.

6. Method according to Claim 1, **characterized in that**, after disconnection and after the specific time period has elapsed, the movement distance difference ($\Delta x$) traveled by the armature and the component (502) is determined by means of a checking element (501) as the initiation device, with the checking element (501) initiating the means for breaking open welded main contacts when the movement distance difference ($\Delta x$) traveled is less than the predetermined value.

7. Method according to Claim 6, **characterized in that** the checking element (501) is an actuator which is operated after disconnection and after the specific time period has elapsed in order to sample a position (503) of the armature and/or of the component (502) connected to it, with the operation of the actuator (501) being blocked or at least restricted by the armature or by the component connected to it when the movement distance difference ($\Delta x$) traveled is not less than the predetermined value.

8. Method according to Claim 7, **characterized in that**, if operation is unimpeded, the actuator (501) operates the means (505-508) which is operatively and mechanically connected to the actuator (501), in order to break open welded main contacts.

9. Apparatus for safe operation of a switching device, with the switching device having at least one main contact which can be connected and disconnected and has contact pieces and a moving contact link, and at least one control magnet (110) which has a moving armature (120) with the armature (120) and the contact link being operatively connected such that the appropriate main contact can be closed or opened during connection or disconnection, **characterized in that**

- an initiation device (150) is provided, which initiates means (180) for breaking open welded main contacts, and
- **in that** the initiation process takes place when, during disconnection, the movement distance difference ($\Delta x$) traveled by the armature (120) or by a component (502) which is mechanically connected to the armature (120) is less than a predetermined value, and a specific time period has elapsed after disconnection.

10. Apparatus according to Claim 9, **characterized in that** the means (180) for breaking open comprises a force energy store, which can be unlatched by the initiation lever (150).

**11.** Apparatus according to Claim 9 or 10, **characterized in that** the initiation device (150) is an initiation lever which is mounted such that it can rotate and is operatively connected at one end to the armature (120) and at the other end to means (170) for production of an opposing force (FF).

**12.** Apparatus according to Claim 11, **characterized in that** a ferromagnetic slotted link (160) is provided, is moved together with the armature (120), is operatively connected to a magnet (151) on the initiation lever (150) and cancels a force link (FM) between the slotted link (160) and the magnet (151) when the movement distance difference ($\Delta x$) traveled by the armature (120) is less than the predetermined value.

**13.** Apparatus according to one of Claims 9 to 11,
**characterized in that** a mechanical coupling device (140) is provided between the armature (120) and the initiation lever (150) and is designed such that the coupling device (140) no longer exerts any force on the initiation lever (150) when the movement distance difference ($\Delta x$) traveled by the armature (120) is not less than the predetermined value.

**14.** Apparatus according to Claim 9, **characterized in that** a checking element (501) is provided as the initiation device, determines the movement distance difference ($\Delta x$) traveled by the armature or by the component (502) after disconnection and after the specific time period has elapsed, and initiates the means for breaking open welded main contacts when the movement distance difference ($\Delta x$) traveled is less than the predetermined value.

**15.** Apparatus according to one of Claims 9 to 11,
**characterized in that** the checking element (501) is an actuator which can be operated after disconnection and after the specific time period has elapsed, in order to sample the position (503) of the armature and/or of the component (502) connected to it, with the latter blocking or at least restricting the operation of the actuator (501) if the movement distance difference ($\Delta x$) traveled is not less than the predetermined value.

**16.** Apparatus according to one of Claims 9 to 11,
**characterized in that**, if operation is unimpeded, the means (505-508) which is operatively and mechanically connected to the actuator (501) can be operated by means of the actuator (501) in order to break open welded main contacts.

**17.** Switching device which carries out the method according to one of Claims 1 to 8 for safe switching of loads, with the switching device being a contactor, a circuit breaker or a compact outgoer.

**18.** Switching device for safe switching of loads having an apparatus according to one of Claims 9 to 16, with the switching device being a contactor, a circuit breaker or a compact outgoer.

**19.** Switching device according to Claim 17 or 18,
**characterized in that** the switching device is a three-pole switching device having three main contacts for connection and disconnection of three current paths by means of a control magnet (120).

**Revendications**

**1.** Procédé destiné à assurer la sécurité de fonctionnement d'un appareil de commutation comprenant au moins un contact principal pouvant être connecté et déconnecté, qui présente des pièces de contact et un pont de contact mobile, et comprenant au moins un aimant de commande (110), qui présente un induit mobile (120), l'induit (120) et le pont de contact se trouvant dans une liaison opérationnelle telle que lors de la connexion ou de la déconnexion le contact principal correspondant (1) peut être fermé ou ouvert, comprenant les étapes :

a) reconnaissance d'une différence de trajet ($\Delta x$) que l'induit (120) resp. un composant (502) raccordé mécaniquement à l'induit (120) parcourt après la connexion ou la déconnexion, et
**caractérisé par**
b) le déclenchement de moyens (180) pour la rupture de contacts principaux soudés au moyen d'un dispositif de déclenchement (150) lorsque la différence de trajet reconnue ($\Delta x$) dépasse vers le bas une valeur prédéfinie et qu'une durée déterminée a expiré après la déconnexion.

**2.** Procédé selon la revendication 1, **caractérisé en ce que** le moyen (180) de rupture comprend un accumulateur de force qui est désencliqueté.

3. Procédé selon la revendication 1 ou 2, **caractérisé en ce que** le déclenchement est réalisé au moyen d'un levier de déclenchement (150) en tant que dispositif de déclenchement, qui est logé de manière rotative, et qui se trouve en liaison opérationnelle avec l'induit (120) sur une extrémité et, sur l'autre extrémité, avec des moyens (170) destinés à générer une force de réaction (FF).

4. Procédé selon la revendication 3, **caractérisé en ce que** la reconnaissance de la différence de trajet ($\Delta$x) est réalisée par une coulisse ferromagnétique (160) qui est déplacée ensemble avec l'induit (120), laquelle se trouve en liaison opérationnelle avec un aimant (151) sur le levier de déclenchement (150) et supprime une liaison de force (FM) entre la coulisse (160) et l'aimant (151) lorsque la différence de trajet ($\Delta$x) parcourue par l'induit (120) a dépassé vers le bas la valeur prédéfinie.

5. Procédé selon l'une quelconque des revendications 1 à 3, **caractérisé en ce que** la reconnaissance de la différence de trajet ($\Delta$x) est réalisée par une liaison (140) entre l'induit (120) et le levier de déclenchement (150), laquelle n'exerce plus de force sur le levier de déclenchement (150) lorsque la différence de trajet ($\Delta$x) parcourue par l'induit (120) ne dépasse pas vers le bas la valeur prédéfinie.

6. Procédé selon la revendication 1, **caractérisé en ce qu'**après la déconnexion et après l'expiration de la durée déterminée, la différence de trajet ($\Delta$x) parcourue par l'induit resp. par le composant (502) est déterminée au moyen d'un élément d'interrogation (501) en tant que dispositif de déclenchement, l'élément d'interrogation (501) déclenchant les moyens de rupture de contacts principaux soudés lorsque la différence de trajet ($\Delta$x) dépasse vers le bas la valeur prédéfinie.

7. Procédé selon la revendication 6, **caractérisé en ce que** l'élément d'interrogation (501) est un acteur, lequel, après la déconnexion et après l'expiration de la durée déterminée, est actionné afin de palper une position (503) de l'induit resp. du composant (502) qui y est raccordé l'actionnement de l'acteur (501) étant bloqué ou tout du moins restreint par l'induit resp. par le composant qui y est raccordé lorsque la différence de trajet ($\Delta$x) parcourue ne dépasse pas vers le bas la valeur prédéfinie.

8. Procédé selon la revendication 7, **caractérisé en ce que** l'acteur (501), en cas de l'actionnement non entravé, actionne les moyens (505-508) se trouvant dans une liaison mécanique opérationnelle avec l'acteur (501) pour rompre des contacts principaux soudés.

9. Dispositif destiné à assurer la sécurité de fonctionnement d'un appareil de commutation, l'appareil de commutation comprenant au moins un contact principal connectable et déconnectable qui présente des pièces de contact et un pont de contact mobile, et au moins un aimant de commande (110) qui présente un induit mobile (120), l'induit (120) et le pont de contact se trouvant dans une liaison opérationnelle telle que, lors de la connexion et de la déconnexion, le contact principal correspondant (1) peut être fermé ou ouvert,
**caractérisé en ce qu'**

- un dispositif de déclenchement (150) est prévu, lequel déclenche des moyens (180) de rupture de contacts principaux soudés, et
- **en ce que** le déclenchement est réalisé lorsque, lors de la déconnexion, la différence de trajet ($\Delta$x) parcourue par l'induit (120) resp. par un composant (502) raccordé mécaniquement à l'induit (120) dépasse vers le bas une valeur prédéfinie, et lorsqu'une durée déterminée a expiré après la déconnexion.

10. Dispositif selon la revendication 9, **caractérisé en ce que** les moyens (180) de rupture comprennent un accumulateur de force qui peut être désencliqueté par le levier de déclenchement (150).

11. Dispositif selon la revendication 9 ou 10, **caractérisé en ce que** le dispositif de déclenchement (150) est un levier de déclenchement qui est logé de manière rotative et qui se trouve en liaison opérationnelle avec l'induit (120) sur une extrémité et, sur l'autre extrémité, avec des moyens (170) destinés à générer une force de réaction (FF).

12. Dispositif selon la revendication 11, **caractérisé en ce qu'**une coulisse ferromagnétique (160) est prévu, laquelle est déplacée ensemble avec l'induit (120) et se trouve en liaison opérationnelle avec un aimant (151) sur le levier de déclenchement (150) et supprime une liaison de force (FM) entre la coulisse et l'aimant (151) lorsque la différence de trajet ($\Delta$x) parcourue par l'induit (120) a dépassé vers le bas la valeur prédéfinie.

**13.** Dispositif selon l'une quelconque des revendications 9 à 11, **caractérisé en ce qu'**un dispositif de couplage mécanique (140) est prévu entre l'induit (120) et le levier de déclenchement (150), lequel dispositif de couplage est réalisé de manière à ce qu'une force ne soit plus exercée sur le levier de déclenchement (150) par le dispositif de couplage (140) lorsque la différence de trajet ($\Delta x$) parcourue par l'induit (120) ne dépasse pas vers le bas la valeur prédéfinie.

**14.** Dispositif selon la revendication 9, **caractérisé en ce qu'**un élément d'interrogation (501) est prévu en tant que dispositif de déclenchement, lequel élément d'interrogation, après la déconnexion et après l'expiration de la durée déterminée, détermine la différence de trajet ($\Delta x$) parcourue par l'induit resp. par le composant (502) et lequel élément d'interrogation déclenche les moyens de rupture de contacts principaux soudés lorsque la différence de trajet ($\Delta x$) dépasse vers le bas la valeur prédéfinie.

**15.** Dispositif selon l'une quelconque des revendications 9 à 11, **caractérisé en ce que** l'élément d'interrogation (501) est un acteur, lequel, après la déconnexion et après l'expiration de la durée déterminée, est actionnable afin de palper une position (503) de l'induit resp. du composant (502) qui y est raccordé, l'actionnement de l'acteur (501) étant bloqué ou tout du moins restreint en raison de celle-ci au cas où la différence de trajet ($\Delta x$) parcourue ne dépasse pas vers le bas la valeur prédéfinie.

**16.** Dispositif selon l'une quelconque des revendications 9 à 11, **caractérisé en ce qu'**en cas de l'actionnement non entravé, les moyens (505-508) se trouvant dans une liaison mécanique opérationnelle avec l'acteur (501), destinés à la rupture de contacts principaux soudés, sont actionnables au moyen de l'acteur (501).

**17.** Appareil de commutation qui, pour la commutation fiable de consommateurs, exécute le procédé selon l'une quelconque des revendications 1 à 8, l'appareil de commutation étant un contacteur-disjoncteur ou un interrupteur de puissance ou un branchement compact.

**18.** Appareil de commutation destiné à assurer la sécurité de commutation de consommateurs à l'aide d'un dispositif selon l'une quelconque des revendications 9 à 16, l'appareil de commutation étant un contacteur-disjoncteur ou un interrupteur de puissance ou un branchement compact.

**19.** Appareil de commutation selon la revendication 17 ou 18, **caractérisé en ce que** l'appareil de commutation est un appareil de commutation tripolaire comprenant trois contacts principaux pour connecter et déconnecter trois voies de courant à l'aide d'un aimant de commande (120).

# FIG 1

```
        ┌─────────────────────┐
        │     Ausschalten      │
        └─────────────────────┘
                   │
                   ▼
        ┌─────────────────────┐
        │      Schnitt a       │
        └─────────────────────┘
                   │
                   ▼
        ┌─────────────────────┐
        │      Schnitt b       │
        └─────────────────────┘
```

FIG 2

110 120 130 140 150 151 160 161 170 180 190

FM FF Δx

FIG 3

FIG 4

FIG 5

## FIG 6

Auslösezeitfenster

F

Ausschaltzeitpunkt

0    1,5    ms

benötigte Auslösezeit

T

Auslösezeitfenster

F

0    ms

benötigte Auslösezeit

T

## FIG 7

Schaltstellung

Ein

Auslösezeitfenster

Aus

0    ms

benötigte Auslösezeit

T

Ein

Auslösezeitfenster

Verschweißt

Aus

benötigte Auslösezeit

T

ms

EP 1 829 066 B1

**FIG 8**

EIN
AUS
Δx

503

502

504

505

506

507

508

501

A

**FIG 9**

EIN
AUS
Δx

503

502

504

505

506

507

508

501

A

19

# FIG 10

ein
verschweisst
aus

503

502

504

505

506

507

508

501

A

**EP 1 829 066 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0694937 A2